# EUROPEAN PATENT SPECIFICATION

(11) **EP 0 752 172 B1**
(45) Date of publication and mention of the grant of the patent: **21.05.2003**
(21) Application number: 95912905.7
(22) Date of filing: 13.03.1995
(51) Int. Cl.: H03D 1/24, H04L 25/03, H04L 27/06, H04N 5/21, H04L 27/02, H04N 5/455, H04N 5/44

(54) **CARRIER INDEPENDENT TIMING RECOVERY SYSTEM FOR A VESTIGIAL SIDEBAND MODULATED SIGNAL**
TRÄGERUNABHÄNGIGES TAKTRÜCKGEWINNUNGSSYSTEM FÜR EIN RESTSEITENBANDMODULIERTES SIGNAL
SYSTEME DE RECUPERATION DE RYTHME INDEPENDANT DE LA PORTEUSE POUR SIGNAL MODULE A BANDE LATERALE RESIDUELLE

(30) Priority: 21.03.1994 GB 9405487
(43) Date of publication of application: 08.01.1997
(73) Proprietor: RCA Thomson Licensing Corporation, Princeton, NJ 08540 (US)
(72) Inventor: STROLLE, Christopher, Hugh, Glenside, PA 19038 (US); JAFFE, Steven, Todd, Freehold, NJ 07728 (US)
(74) Representative: Ruellan-Lemonnier, Brigitte
(86) International application number: US9503131
(87) International publication number: WO95026074

(56) References cited:
- US-A- 4 358 853
- US-A- 4 642 573
- US-A- 4 802 191
- US-A- 5 278 655
- US-A- 5 398 073

## Description

### Field of the Invention

This invention concerns a digital signal processing system. In particular, the invention concerns a timing recovery system for use in a receiver of a vestigial side band (VSB) signal such as may be modulated with high definition television (HDTV) information, for example.

### Background of the Invention

The recovery of data from a VSB or a QAM (Quadrature Amplitude Modulated) signal at a receiver requires the implementation of three functions: timing recovery for symbol synchronization, carrier recovery (frequency demodulation) and equalization. Timing recovery is the process by which the receiver clock (timebase) is synchronized to the transmitter clock. This permits the received signal to be sampled at the optimum point in time to reduce the chance of a slicing error associated with decision-directed processing of received symbol values. Carrier recovery is the process by which a received RF signal, after being frequency shifted to a lower intermediate frequency passband, is frequency shifted to baseband to permit recovery of the modulating baseband information. Equalization is a process which compensates for the effects of transmission channel disturbances upon the received signal. More specifically, equalization removes intersymbol interference (ISI) caused by transmission channel disturbances. ISI causes the value of a given symbol to be distorted by the values of preceding and following symbols.

For QAM signals, timing recovery is usually the first function implemented in a receiver. The timing is recovered from either the intermediate passband signal or from a near-baseband signal, i.e ., a baseband signal with a carrier offset that is corrected by the carrier recovery network. In either case, timing can be established prior to baseband demodulation.

A QAM signal conveying digital information is represented by a two-dimensional data symbol constellation defined by Real and Imaginary axes. In contrast, a VSB signal is represented by a one-dimensional data symbol constellation wherein only one axis contains quantized data to be recovered at a receiver. Timing recovery for a baseband VSB signal can be achieved using periodic synchronizing (sync) symbols or components. This technique is used by a terrestrial broadcast Grand Alliance HDTV system recently proposed for the United States. A significant drawback of this technique is that the use of such sync symbols reduces the payload capacity of the data transmission channel.

The Grand Alliance HDTV system employs a vestigial sideband (VSB) digital transmission format for transmitting a packetized datastream. This HDTV system is a proposed transmission standard that is under consideration in the United States by the Federal Communications Commission through its Advisory Committee of Advanced Television Service (ACATS). In this system, data is arranged as a sequence of data fields. Each field includes 313 segments: a field sync segment (which does not contain payload data) followed by 312 data segments. A sync component is associated with each data segment. A description of the Grand Alliance HDTV system as submitted to the ACATS Technical Subgroup on February 22, 1994 (draft document) is found in the 1994 Proceedings of the National Association of Broadcasters, 48th Annual Broadcast Engineering Conference Proceedings, March 20-24, 1994.

### Summary of the Invention

A disclosed timing recovery system, suitable for use with VSB signals, advantageously achieves timing recovery without reliance upon sync components. This is accomplished using band edge timing recovery with respect to a received VSB signal to develop double sideband amplitude modulated signals from which timing information is extracted. In an illustrated embodiment, a band edge filter network filters upper and lower band edges of the VSB signal. The disclosed system advantageously operates at the symbol rate, does not rely on a received signal containing bandwidth limiting synchronizing components to facilitate timing recovery, and is capable of achieving timing synchronism independent of a carrier offset when present.

In a disclosed embodiment, the filter network is a complex digital filter network with responses that are complementary to the frequency spectrum of the received VSB signal at band edges filtered by the filter network.

In accordance with a feature of the invention, the filter network is shared by a carrier recovery network for frequency shifting the received VSB signal toward baseband.

### Brief Description of the Drawings

Figure 1 is a block diagram of a portion of an advanced television receiver, such as a HDTV receiver, including a timing recovery system in accordance with the principles of the invention.
Figures 2-6 illustrate amplitude versus frequency responses of signals associated with the operation of the system of Figure 1.

### Detailed Description of the Drawings

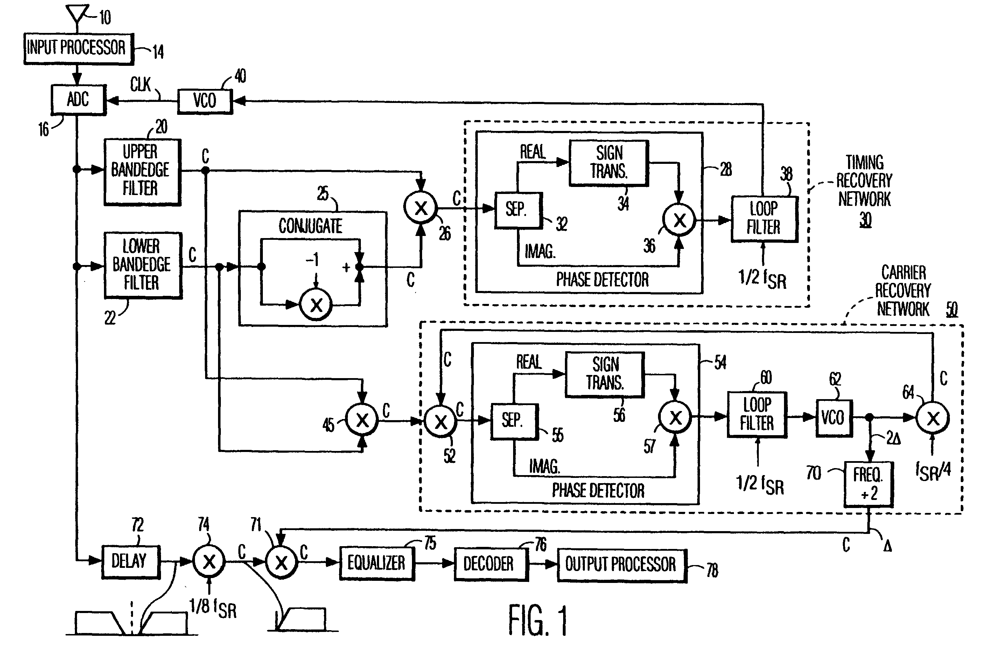

In Figure 1, a broadcast VSB modulated HDTV analog signal received by an antenna 10 is processed by an input network 14 including RF tuning circuits, a double conversion tuner for producing an intermediate frequency passband suitable for conversion to digital form and appropriate gain control circuits, for example. The received VSB signal illustratively is an 8-VSB signal with a symbol rate of approximately 10.76 Msymbols/second occupying a conventional NTSC 6 MHz frequency spectrum, in accordance with the Grand Alliance HDTV specification. Specifically, the received VSB signal in this example is an 8-VSB signal having a one dimensional data constellation defined by the following eight data symbols:
-7 -5 -3 -1 1 3 5 7
The Nyquist bandwidth for this system is nominally 5.38 MHz for example, with excess bandwidth nominally 0.31 MHz at each bandedge. The disclosed system may also be used for 16-VSB signals, for example.

The output signal from input processor 14 is converted from analog to digital form by an analog-to-digital converter 16, which operates at a sample rate of 2 samples/symbol. The received VSB signal may include a pilot component and has been demodulated by unit 14 so that the center of the 6 MHz band is nominally situated at 5.38 MHz. The frequency spectrum of this signal at the input of ADC 16 occupies a range of 2.38 MHz to 8.38 MHz. When timing synchronization is established, ADC unit 16 samples this signal at 21.52 MHz, which is twice the symbol rate. The pilot component, which represents the DC point of the original baseband pulse amplitude modulated (PAM) signal, is nominally situated at 2.69 MHz (the Nyquist frequency), which is 1/8 fₛᵣ. In the following discussion

f_{c} is the carrier frequency of the transmitted signal (nominally 5.38 MHz),

fₛₜ is the transmitted symbol frequency (10.76 Msymbols/sec, or four times the Nyquist frequency), and

fₛᵣ is the receiver sampling frequency (21.52 Mhz). At timing lock, fₛᵣ = 2fₛₜ. At carrier lock when demodulation to baseband results, f_{c} = 1/4 fₛᵣ.

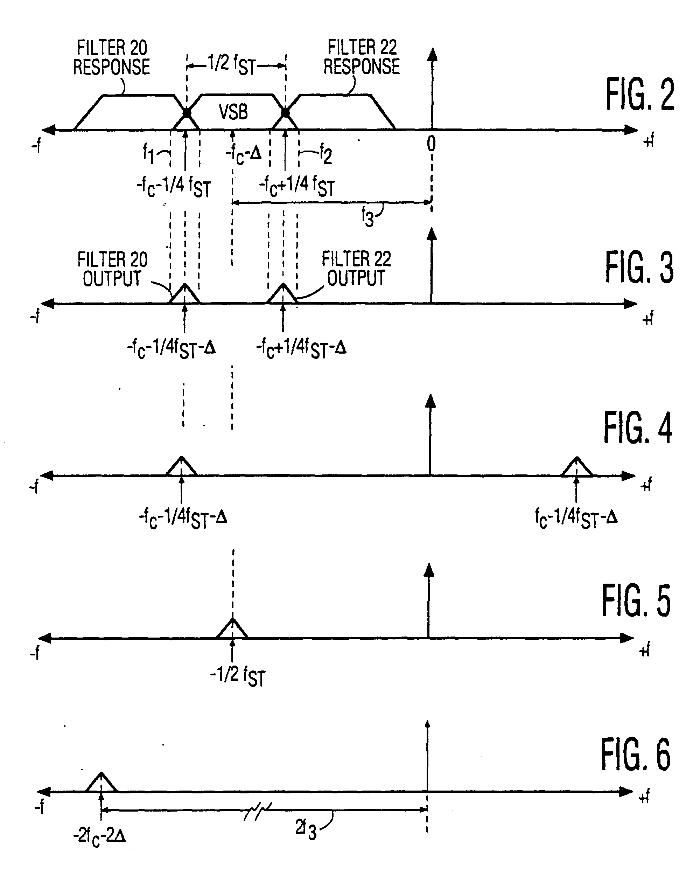

The digital signal from ADC unit 16 is applied to two complex bandedge filters 20 and 22, which are mirror image filters around the Nyquist frequency. Each filter exhibits real and imaginary functions so that output signals from these filters contain real and imaginary components. In Figure 1, a letter "C" designates those signal paths which convey complex signals with real and imaginary components. Other signal paths convey only real components. Filters 20 and 22 produce output signals without image components, i.e ., the output signals contain either positive or negative spectral components but not both. This has the advantage of not generating spurious components that may be difficult to remove subsequently. In this system filters 20 and 22 are designed to have complex analytic output signals with negative spectral components as will be seen from Figure 2. The negative spectrum is arbitrary; the positive spectrum also could have been chosen.

Figure 2 depicts the negative frequency spectrum encompassed by the bandpass responses of filters 20 and 22, and by the bandwidth of the received VSB signal as applied to the inputs of filters 20 and 22. The input real signal has positive and negative spectra. The positive spectrum is cancelled using known techniques, leaving the negative spectrum. Filter 20 extracts the upper bandedge of the negative spectrum of the VSB signal, and filter 22 extracts the lower bandedge of the negative spectrum of the VSB signal. The upper bandedge is that which contains the highest frequency components, regardless of whether they are positive or negative components. The lower bandedge is associated with the lowest frequency components. The bandedge responses of filters 20, 22 and the VSB signal intersect at the Nyquist points in this example. In Figure 2 and subsequent Figures, a symbol "Δ" designates a carrier frequency offset such as may be associated with a near-baseband signal, i.e ., a signal not completely frequency shifted to baseband. This offset will be discussed in detail in connection with the carrier recovery (baseband demodulation) network.

The responses of filters 20 and 22 are complementary to the frequency spectrum of the input signal at the bandedge the filters are extracting, as shown in Figure 2. This has the effect of producing a double sideband suppressed carrier amplitude modulated (AM) signal when no pilot component is present in the received VSB signal (Figure 3), and producing a double sideband residual carrier AM signal when a pilot is present in that bandedge. The response of filter 20 to the left of frequency f₁ is not critical, and the response of filter 22 to the right of frequency f₂ is not critical.

Prior to establishing timing and carrier lock, these AM signals contain frequency (and phase) offsets that may be used for timing and carrier recovery. Specifically, the center of the AM signal obtained from the output of upper bandedge filter 20 is situated at -f_{c}-1/4 fₛₜ. If a pilot signal is present (such as in the Grand Alliance HDTV system), it would appear at this frequency. The frequency 1/4 fₛₜ is one-fourth the symbol frequency if the signal is treated as a VSB signal. Similarly, the center of the AM signal obtained from the output of the lower bandedge filter is situated at -f_{c} + 1/4 fₛₜ (the Nyquist frequency). Timing synchronization is achieved when the frequency of the sampling clock input (CLK) of ADC unit 16 is four times the frequency difference between the carriers of these two upper and lower suppressed carrier band edge AM signals (Figure 3).

The timing recovery system operates as follows. The output signal from filter 22 is conjugated by unit 25 to flip the spectrum of the filter 22 output signal from negative to positive. This is illustrated by Figure 4. Conjugation is a well-known process performed in unit 25 by first separating the signal into its real and imaginary components using well-known methods. The imaginary component is inverted by multiplying it by a negative unity factor. The inverted imaginary component and the original real component are re-combined. The recombined lower bandedge AM signal is multiplied with the upper bandedge AM signal from filter 20 in multiplier 26. An AM signal produced at the output of multiplier 26 has carrier frequency component f_{c} removed, as illustrated by Figure 5. Removal of this f_{c} component results because the negative carrier of the upper bandedge component cancels the positive carrier of the conjugated AM signal from the lower bandedge. The AM signal at a suppressed carrier center frequency of 1/2 fₛₜ is maintained because both of the multiplied AM signals are double sideband signals. In the frequency domain these signals are represented at baseband as even functions (i.e ., as real only components), and their convolution is represented at baseband as even valued functions.

The bandwidth of the AM output signal from multiplier 26 has been doubled by the convolution process (multiplication in time produces convolution in frequency). By driving every other sample to zero, the frequency of the receiver sampling clock CLK can be synchronized to the symbol frequency of the input VSB signal independent of any carrier offset (Δ). This is accomplished by a phase detector 28 in a timing recovery network 30 as follows.

The imaginary component of the double sideband AM output signal from multiplier 26 (Figure 5) is an indication of the magnitude of signal mis-timing. The real component indicates the direction of the mis-timing (AM suppressed carrier signals have an ambiguity of 180 degrees which is to be resolved). If this AM signal is perfectly timed, the imaginary component is absent. The double sideband AM signal from multiplier 26 is separated into its constituent real and imaginary components by means of a unit 32 in phase detector 28 using known separation techniques. Using known techniques, a translation unit 34 determines the sign of real component (for direction information), and multiplies this sign by the separated imaginary component samples. The output of multiplier 36 represents an error signal which is driven to zero by the action of the timing control loop when timing lock is achieved.

Since the carrier frequency of the double sideband signal is nominally situated at 1/2 fₛᵣ, at lock of the imaginary component of the output signal from multiplier 36 will be zero. Multiplying the imaginary component with the sign of the real component gives phase detector 28 the ability to differentiate between positive and negative frequency offsets.

The output signal from phase detector 28 is filtered by a low pass loop filter 38 which contains both an integral path and a proportional path, as known, and is clocked at a frequency of 1/2 fₛᵣ. Loop filter 38 is clocked to process every other sample of the input signal since the purpose of the loop is to drive every other sample of the imaginary component to zero. The output of filter 38 is a DC voltage which is applied to a voltage controlled oscillator (VCO) 40. Oscillator 40 provides the receiver sampling clock CLK for ADC unit 16 as a function of the DC voltage. Timing synchronism is achieved when the ADC sampling clock provided by the described timing recovery system including network 30 is four times the frequency difference between the carriers of the two AM output signals from filters 20 and 22 (Figure 3). The proportional and integral control portions of filter 38 are adjustable as known by using K1 and K2 gain control scalars respectively. These scalars are set to large values to facilitate signal acquisition in the acquisition mode, and may be reduced in value during the tracking mode to increase noise immunity. The time required to achieve timing lock varies as a function of the amount of noise and multipath distortion present in the signal, the control loop bandwidth, and the control loop time constants, for example.

The carrier can be recovered using two different methods in the system of Figure 1. One method uses both of the bandedge AM signals from the outputs of filters 20 and 22 in a manner that is similar to that described above for timing recovery. The second method uses only one bandedge of the received signal. In the second case, typically the bandedge which is used is that which may contain the pilot. The extra energy associated with the pilot component enhances the performance of the carrier recovery loop in low signal-to-noise conditions. It is noted, however, that both of these methods advantageously do not require the presence of a pilot component.

The carrier recovery method using both band edges multiplies the outputs of filters 20 and 22 together in a multiplier 45 without conjugating the signal as was done for timing recovery. This multiplication produces a suppressed carrier AM signal at the output of multiplier 45 with a carrier frequency of -2f_{c}. The symbol rate component fₛₜ has been completely removed from this AM signal. If a carrier offset (Δ) exists, the carrier frequency is at -2f_{c}-2Δ as depicted in Figure 6. Up to this point, the carrier recovery process is independent of the receiver demodulator sampling clock frequency, fₛᵣ.

In digital signal processing applications, it is generally desirable to design voltage controlled oscillators (VCOs) or spectral shifters that conveniently produce signals which are harmonically related to the clock frequency of the digital signal processor. In this regard it is noted that the complex double sideband AM signal at the output of multiplier 45 (Figure 6) is centered at a frequency of -2f_{c} (neglecting any carrier offset), or at -2f_{c}-2Δ (including the offset). This means that this AM signal is straddling the aliasing foldover region. More specifically, in practice, the left sideband portion of the AM signal shown in Figure 6 actually "wraps around" into the positive frequency spectrum. Aliasing does not occur because this AM signal is a complex signal in which the adjacent positive frequency component of the first negative repeat band has been removed.

To simplify the design of the carrier recovery network, an associated phase detector 54 is essentially the same as phase detector 28 used in timing recovery network 30. In order to do achieve this, the carrier of the AM input signal to phase detector 54 must be driven to 1/4 fₛᵣ. The carrier of the AM signal input to phase detector 54 is nominally shifted to a frequency of 1/4 fₛᵣ by using a complex spectral shifter operating at +1/4 fₛᵣ. The spectral shifter comprises complex multipliers 52 and 64. Multiplier 64 responds to a 1/4 fₛᵣ sampling signal for shifting the output signal of VCO 62 by +1/4 fₛᵣ. The response of VCO 62 is similar to VCO 40 in the timing control loop, and responds to a DC voltage produced by a low pass loop filter 60 which is similar to filter 38 in the timing recovery loop. A resulting complex output signal from multiplier 64, which contains the frequency offset generated by the loop plus the fixed 1/4 fₛᵣ, is applied to an input of complex multiplier 52. The other input of multiplier 52 receives the AM signal centered at -2f_{c} from the output of complex multiplier 45.

Phase detector 54 operates the same as phase detector 28 in the timing recovery loop. Phase detector 54 includes a real/imaginary component separator 55, a sign function translation network 56, and an output multiplier 57. Phase detector 54 operates by multiplying the imaginary component of the output signal from multiplier 52 with the sign of the real component. This causes the value of every other sample of the imaginary component to be driven to zero. Since phase detector 54, like phase detector 28, operates on the same set of samples (i.e., odd or even, but not both), loop filter 60 (like filter 38) is required to supply output samples at the symbol rate rather than at twice the symbol rate. This significantly reduces the complexity of the loop filters compared to what would be required for 2 sample per symbol implementations.

The output of multiplier 45, at the input to carrier recovery network 50, is a complex double sideband suppressed carrier AM signal centered at a frequency -2f_{c}-2Δ. The output of VCO 62 in the carrier loop is a signal approximately equal to 2Δ. To produce this signal at the output of VCO 62, a signal 1/4 fₛᵣ is added to the carrier loop via multiplier 64 to cancel the 2f_{c} component. The complex signal 2Δ at the output of VCO 62 is translated to an output signal Δ of carrier recovery network 50 by means of a divide-by-2 frequency divider 70. Output signal Δ is a tone (without a frequency spectrum) representing the carrier phase/frequency offset.

The VSB output signal from ADC unit 16 is applied to an input of multiplier 74 after being delayed by a unit 72, which compensates for the signal delay through filters 20 and 22. The output of delay unit 72 is a complex near baseband symmetrical double sideband VSB signal as depicted by the frequency spectrum diagram adjacent to block 72. This signal is shifted to closer to baseband by multiplier 74, which is clocked at 1/8 fₛᵣ to produce a near baseband upper VSB sideband at its output, as depicted by the frequency spectra diagram at the output of multiplier 74. The near baseband VSB signal from the output of multiplier 74 is applied to one input of a complex multiplier 71, and the output (offset representative) signal Δ from the output of carrier recovery network 50 is applied to another input of multiplier 71. The function of multiplier 71 is to substantially cancel the offset Δ in the VSB signal so that a baseband VSB signal results.

A complex demodulated VSB signal appearing at the output of multiplier 71 should be at baseband and often is. However, in practice this signal may contain residual phase offsets that may have to be compensated for. This is accomplished by an equalizer 75, which may be of a known configuration. Equalizer 75 compensates for channel disturbances as known and produces an equalized output signal that is decoded by unit 76 and processed by an output processor 78. Decoder 76 may include, for example, trellis decoder, de-interleaver, Reed-Solomon error correction, and audio/video decoder networks as known. Output processor 78 may include audio and video processors and audio and video reproduction devices.

Carrier recovery can also be accomplished using a single band edge of the input signal, as follows. Lower band edge filter 22 produces a double sideband AM output signal with a carrier frequency of -f_{c} + 1/4 fₛₜ. This is accomplished by setting the input to multiplier 45 from filter 20 to a value of unity. This may be done by placing a multiplexer in the signal path between the output of filter 20 and the upper input of multiplier 45. One input of the multiplexer receives the output signal from filter 20, and another input receives a unity value signal. The latter signal is conveyed to the input of multiplier 45 in response to a control signal applied to a control input of the multiplexer. The output signal from upper band edge filter 20 is decoupled from multiplier 45 when the unity value signal is employed. In a system using two band filters, timing and carrier lock may occur at about the same time. In a system using only one band edge filter, carrier lock may occur after timing lock, depending on a variety of factors such as noise, loop gain and loop bandwidth.

If timing lock has been established by network 30, then fₛₜ = 1/4 fₛᵣ, and the fₛₜ component of the carrier can be removed by shifting the AM output signal of filter 22 with a -1/8 fₛᵣ spectral shifter. This spectral shifting is accomplished in Figure 1 by changing the illustrated 1/4 fₛᵣ clock input to multiplier 64 to a -1/8 fₛᵣ clock. After such spectral shifting, the AM signal carrier at the output of multiplier 52 will be at a frequency -f_{c} (in contrast to -2f_{c} in the case of the double band edge method discussed previously).

In this embodiment the AM signal carrier frequency fc can be easily driven to -1/4 fₛᵣ by using a phase detector similar to unit 54 used for the double band edge carrier recovery example and forcing every other sample of the real component to zero. The output of the phase detector is integrated by a low pass loop filter which drives a VCO in a loop which acts to drive the AM signal carrier frequency to -1/4 fₛᵣ in a manner analogous to that described above in connection with the double band edge carrier recovery example.

In the described embodiments, timing recovery (lock) may be achieved even in the presence of a carrier offset, and timing lock does not rely on sync components in the VSB signal for this purpose. The choice of operating phase detectors 28 and 54 at the midpoint of the Nyquist region is one possible implementation. However, the phase detectors could also be operated at baseband with the same results. The use of the negative frequency spectrum is arbitrary. The positive spectrum could also have been used with analogous results, by using a different implementation of the described circuits. For example, conjugate filters 20 and 22 would be used and the input to multiplier 64 would be -1/4 fₛᵣ.

## Claims

1. In a system for receiving a high definition television (HDTV) signal transmitted as a modulated vestigial sideband (VSB) signal formatted as a one-dimensional data constellation of symbols representing digital image data and subject to exhibiting a carrier offset, apparatus for establishing timing synchronism between a local receiver symbol clock and a transmitter symbol clock, said apparatus being capable of achieving said synchronism independent of said carrier offset when present in said received signal, said apparatus comprising:
an input network (14,16) for receiving said VSB signal;
a filter network responsive to an output signal from said input network, comprising a first band edge filter (20) and a second band edge filter (22), having band edge responses respectively associated with upper and lower band edges of a frequency spectrum of said VSB signal for producing double sideband amplitude modulated (AM) signals at respective outputs of said first and second filters:
a timing recovery networks including phase detector circuitry (28,38) for processing said double sideband AM output signal from said filter network to produce a control signal representative of a timing error; and
a clock signal generator (40) responsive to said control signal for generating said symbol clock.

2. A system according to claim 1, wherein
said first and second filters are complex digital filters with responses that are complementary to the frequency spectrum of the VSB input signal at band edges that said filters respectively filter.

3. A system according to claim 1, wherein
said received VSB signal exhibits a frequency spectrum with band edge responses at a frequencies fc - 1/4 fₛₜ and f_{c} + 1/4 fₛₜ respectively, with respect to a mid-band carrier frequency f_{c} +/Δ; and
said first filter exhibits a band edge response at a Nyquist frequency f_{c} - 1/4 fₛₜ and said second filter exhibits a band edge response at a Nyquist frequency f_{c} + 1/4 fₛₜ, where
f_{c} is the carrier frequency of said transmitted VSB signal;
fₛₜ is the transmitted symbol frequency; and
Δ is a carrier offset when present.

4. A system according to claim 1, wherein
said input network includes an analog-to-digital converter (16) for converting a received signal to digital form, said converter being response to said symbol clock.

5. A system according to claim 1 and further including
a multiplier (26) having first and second inputs for receiving output signals from said filters, respectively, and an output coupled to an input of said phase detector network.

6. A system according to claim 5, and further including:
means (25) for conjugating one of the output signals from said first and second filters before being applied to said multiplier.

7. A system according to claim 5, wherein
an output signal of said multiplier is a suppressed carrier double sideband AM signal centered around a frequency 1/2 fₛₜ, where fₛₜ is the transmitted symbol frequency.

8. A system according to claim 1, wherein
said input signal to said phase detector network is a complex signal having real and imaginary components; and
said phase detector network includes means for cancelling said imaginary component in an output signal from said phase detector network.

9. A system according to claim 1, wherein
said received VSB signal is an 8-VSB signal having a one dimensional data symbol constellation defined by the following eight data symbols: -7 -5 -3 -1 1 3 5 7.

10. In a system for receiving a high definition television (HDTV) signal transmitted as a vestigial sideband (VSB) modulated signal formatted as a one-dimensional data constellation of symbols representing digital image data, apparatus comprising:
an input network (14,16) for receiving said VSB signal;
a filter network responsive to an output signal from said input network, comprising a first band edge filter (20) and a second band edge filter (22) having band edge responses respectively associated with upper and lower band edges of a frequency spectrum of said VSB signal for producing double sideband amplitude modulated (AM) signals at respective outputs of said first and second filters;
a timing recovery network (30) responsive to output signals from said first and second filters for establishing timing synchronism between a local receiver symbol clock and a transmitter symbol clock; and
a carrier recovery network (50) responsive to output signals from said first and second filters for frequency shifting said received VSB signal toward baseband.

11. A system according to claim 10, wherein
said first and second filters are digital filters with responses that are complementary to the frequency spectrum of said input VSB signal at band edges said filters respectively filter.

## Patentansprüche

1. System zum Empfang eines hochauflösenden Femsehsignals (HDTV), das als ein moduliertes Restseitenband (VSB)-Signal übertragen wird, das als eine eindimensionale Datenkonstellation von Symbolen formatiert ist, die digitale Bilddaten darstellen und einen Trägeroffset aufweisen, mit einer Vorrichtung zur Bildung eines Takt-Synchronismus zwischen einem Symboltakt eines örtlichen Empfängers und einem Sender-Symboltakt, wobei die Vorrichtung den Synchronismus unabhängig von dem Trägeroffset erreichen kann, wenn dieser in dem empfangenen Signal vorhanden ist, mit:
einem Eingangsnetzwerk (14, 16) zum Empfang des VSB-Signals,
einem Filtemetzwerk, das durch ein Ausgangssignal von dem Eingangsnetzwerk gesteuert wird, mit einem ersten Bandkantenfilter (20) und einem zweiten Bandkantenfilter (22) mit einem Bandkantenverlauf, der jeweils der oberen und der unteren Bandkante eines Frequenzspektrums des VSB-Signals zugeordnet ist, zur Erzeugung von amplitudenmoduliertem Doppelseitenband (AM)-Signalen an Ausgängen des ersten bzw. des zweiten Filters,
einem Taktrückgewinnungsnetzwerk mit einer Phasendetektorschaltung (28, 38) zur Verarbeitung des Doppelseitenband-AM-Ausgangssignals von dem ersten Filtemetzwerk zur Erzeugung eines einen Taktfehler anzeigenden Steuersignals und
einem Taktsignalgenerator (40), der durch das Steuersignal gesteuert wird, zur Erzeugung des Symboltaktes.

2. System nach Anspruch 1, wobei
das erste und das zweite Filter komplexe digitale Filter mit Kennlinien sind, die komplementär sind zu dem Frequenzspektrum des VSB-Eingangssignals an den Bandkanten, die die jeweiligen Filter filtern.

3. System nach Anspruch 1, wobei
das empfange VSB-Signal ein Frequenzspektrum mit Bandkantenverläufen bei den Frequenzen f_{c} - 1/4 fₛₜ bzw. f_{c} + 1/4fₛₜ bezüglich einer Trägerfrequenz f_{c} +/- Δ in der Mitte des Bandes aufweist, und
das erste Filter einen Bandkantenverlauf bei einer Nyquistfrequenz f_{c} - 1/4fₛₜ und das zweite Filter einen Bandkantenverlauf bei einer Nyquistfrequenz f_{c} + 1/4fₛₜ aufweist, wobei
f_{c} die Trägerfrequenz des übertragenen VSB-Signals,
fₛₜ die übertragene Symbolfrequenz und
Δ ein Trägeroffset ist, wenn ein solcher anwesend ist.

4. System nach Anspruch 1, wobei
das Eingangsnetzwerk einen Analog/Digital-Konverter (16) zur Konvertierung eines empfangenen Signals in digitaler Form aufweist und der Konverter durch den Symboltakt gesteuert wird.

5. System nach Anspruch 1 mit:
einem Multiplizierer (26) mit einem ersten bzw. einem zweiten Eingang zum Empfang der Ausgangssignale von den Filtern und einem Ausgang, der mit einem Eingang des Phasendetektometzwerks verbunden ist.

6. System nach Anspruch 5 mit:
Mitteln (25) zur Konjugation des Ausgangssignals von dem ersten oder dem zweiten Filter, bevor es dem Multiplizierer zugeführt wird.

7. System nach Anspruch 5, wobei
ein Ausgangssignal des Multiplizierers ein Doppelseitenband-AM-Signal mit unterdrücktem Träger ist, das um eine Frequenz 1/2 fₛₜ zentriert ist, wobei fₛₜ die übertragene Symbolfrequenz ist.

8. System nach Anspruch 1, wobei
das Eingangssignal zu dem Phasendetektometzwerk ein komplexes Signal mit einer realen und einer imaginären Komponente ist und
das Phasendetektometzwerk Mittel zur Beseitigung der imaginären Komponente in einem Ausgangssignal von dem Phasendetektornetzwerk enthält.

9. System nach Anspruch 1, wobei
das empfangene VSB-Signal ein 8-VSB-Signal mit einer eindimensionalen Datensymbol-Konstellation ist, die durch die folgenden acht Datensymbole definiert ist:-7 -5 -3 -1 1 3 5 7.

10. System zum Empfang eines hochauflösenden Fernsehsignals (HDTV), das als ein Restseitenband (VSB)-moduliertes Signal übertragen wird, das als eine eindimensionale Datenkonstellation von Symbolen formatiert ist, die digitale Bilddaten darstellen, mit einer Vorrichtung mit folgenden Merkmalen:
ein Eingangsnetzwerk (14, 16) zum Empfang des VSB-Signals,
ein Filternetzwerk, das durch ein Ausgangssignal von dem Eingangsnetzwerk gesteuert wird, mit einem ersten Bandkantenfilter (20) und einem zweiten Bandkantenfilter (22) mit Bandkantenverläufen für die obere bzw. die untere Bandkante eines Frequenzspektrums des VSB-Signals zur Erzeugung der im Doppelseitenband amplitudenmodulierten (AM)-Signale an Ausgängen des ersten bzw. des zweiten Filters,
ein Taktrückgewinnungsnetzwerk (30), das durch Ausgangssignale von dem ersten und dem zweiten Filter gesteuert wird, zur Bildung des Taktsynchronismus zwischen dem Symboltakt eines örtlichen Empfängers und einem Symboltakt des Senders und
ein Trägerrückgewinnungsnetzwerk (50), das durch Ausgangssignale von dem ersten und dem zweiten Filter gesteuert wird, zur Frequenzverschiebung des empfangenen VSB-Signals in das Basisband.

11. System nach Anspruch 10, wobei
das erste und das zweite Filter digitale Filter mit Kennlinien sind, die komplementär zu dem Frequenzspektrum des Eingangssignals VSB an den Bandkanten sind, die die jeweiligen Filter filtern.

## Revendications

1. Dans un système pour recevoir un signal de télévision de haute définition (THD) transmis sous forme de signal à bande latérale résiduelle (VSB) modulé, formaté en tant que constellation de données unidimensionnelle de symboles représentant des données d'images numériques et sujet à présenter un décalage de porteuse, dispositif pour établir un synchronisme de cadencement entre une horloge de symboles de récepteur local et une horloge de symboles d'émetteur, ledit dispositif pouvant réaliser ce synchronisme indépendamment dudit décalage de porteuse lorsqu'il est présent dans ledit signal reçu, ledit dispositif comprenant :
un réseau d'entrée (14, 16) pour recevoir ledit signal VSB ;
un réseau de filtres sensible à un signal de sortie dudit réseau d'entré, comprenant un premier filtre de bord de bande (20) et un deuxième filtre de bord de bande (22), ayant des réponses en bord de bande associées respectivement aux bords de bande supérieur et inférieur d'un spectre de fréquences dudit signal VSB pour produire des signaux modulés en amplitude (AM) à double bande latérale au niveau de sorties respectives desdits premier et deuxième filtres ;
des réseaux de récupération de cadencement comportant des circuits détecteurs de phase (28, 38) pour traiter ledit signal de sortie AM à double bande latérale provenant dudit réseau de filtres afin de produire un signal de commande représentatif d'une erreur de cadencement ; et
un générateur de signaux d'horloge (40) sensible audit signal de commande pour générer ladite horloge de symboles.

2. Système selon la revendication 1, dans lequel
lesdits premier et deuxième filtres sont des filtres numériques complexes ayant des réponses qui sont complémentaires au spectre de fréquences dudit signal VSB reçu au niveau des bords de bande que lesdits filtres filtrent respectivement.

3. Système selon la revendication 1, dans lequel
ledit signal VSB reçu présente un spectre de fréquences avec des réponses en bord de bande à des fréquences fc - 1/4 fst et fc + 1/4 fst respectivement, relativement à une fréquence porteuse à mi-bande fc +/Δ ; et
ledit premier filtre présente une réponse en bord de bande à une fréquence de Nyquist fc - 1/4 fst et ledit deuxième filtre présente une réponse en bord de bande à une fréquence de Nyquist fc + 1/4 fst, où
fc est la fréquence porteuse dudit signal VSB transmis ;
fst est la fréquence des symboles transmis ; et
Δ est un décalage de porteuse lorsqu'il est présent.

4. Système selon la revendication 1, dans lequel
ledit réseau d'entrée comporte un convertisseur analogique/numérique (16) pour convertir un signal reçu en forme numérique, ledit convertisseur répondant à ladite horloge de symboles.

5. Système selon la revendication 1, et comportant en outre
un multiplicateur (26) ayant des première et deuxième entrées pour recevoir des signaux de sortie desdits filtres, respectivement, et une sortie couplée à une entrée dudit réseau de détecteurs de phase.

6. Système selon la revendication 1, et comportant en outre :
un moyen (25) pour conjuguer l'un des signaux de sortie desdits premier et deuxième filtres avant de l'appliquer audit multiplicateur.

7. Système selon la revendication 5, dans lequel
un signal de sortie dudit multiplicateur est un signal AM à double bande latérale à porteuse supprimée centré autour d'une fréquence 1/2 fst, où fst est la fréquence des symboles transmis.

8. Système selon la revendication 1, dans lequel ledit signal d'entrée dudit réseau de détecteurs de phase est un signal complexe ayant des composantes réelles et ;
ledit réseau de détecteurs de phase comporte un moyen pour supprimer ladite composante imaginaire dans un signal de sortie dudit réseau de détecteurs de phase.

9. Système selon la revendication 1, dans lequel
ledit signal VSB reçu est un signal VSB-8 ayant une constellation de données unidimensionnelle définie par les huit symboles de données suivants : -7 -5 -3 -1 1 3 5 7.

10. Dans un système pour recevoir un signal de télévision de haute définition (THD) transmis sous forme de signal à bande latérale résiduelle (VSB) modulé, formaté en tant que constellation de données unidimensionnelle de symboles représentant des données d'images numériques, un dispositif comprenant :
un réseau d'entrée (14, 16) pour recevoir ledit signal VSB ;
un réseau de filtres sensible à un signal de sortie dudit réseau d'entrée, comprenant un premier filtre de bord de bande (20) et un deuxième filtre de bord de bande (22), ayant des réponses en bord de bande associées respectivement aux bords de bande supérieur et inférieur d'un spectre de fréquences dudit signal VSB pour produire des signaux modulés en amplitude (AM) à double bande latérale au niveau de sorties respectives desdits premier et deuxième filtres ;
un réseau de récupération de cadencement (30) sensible à des signaux de sortie desdits premier et deuxième filtres pour établir un synchronisme de cadencement entre une horloge de symboles de récepteur local et une horloge de symboles d'émetteur ; et
un réseau de récupération de porteuse (50) sensible à des signaux de sortie desdits premier et deuxième filtres pour décaler en fréquence ledit signal VSB reçu vers la bande de base.

11. Système selon la revendication 10, dans lequel
lesdits premier et deuxième filtres sont des filtres numériques ayant des réponses qui sont complémentaires au spectre de fréquences dudit signal VSB d'entrée au niveau des bords de bande que lesdits filtres filtrent respectivement.
